# EUROPÄISCHE PATENTSCHRIFT

(11) **EP 3 889 633 B1**
(45) Veröffentlichungstag und Bekanntmachung des Hinweises auf die Patenterteilung: **07.09.2022**
(21) Anmeldenummer: 21164950.4
(22) Anmeldetag: 25.03.2021
(51) Int. Cl.: G01R 33/3875, G01R 33/3815, H01F 6/06

(54) **SHIM-VORRICHTUNG MIT EINER HOCHTEMPERATURSUPRALEITENDEN SHIM-LEITERBAHN, MAGNETANORDNUNG UND VERFAHREN ZUM LADEN EINER HTS-SHIM-VORRICHTUNG**
SHIM DEVICE HAVING A HIGH TEMPERATURE SUPERCONDUCTING SHIM CONDUCTOR TRACK, A MAGNET ARRANGEMENT AND A METHOD OF LOADING AN HTS SHIM DEVICE
DISPOSITIF DE SHIM DOTÉ D'UNE LIGNE SUPRACONDUCTRICE À HAUTE TEMPÉRATURE, AGENCEMENT MAGNÉTIQUE ET PROCÉDÉ DE CHARGE D'UN DISPOSITIF DE SHIM HTS

(30) Priorität: 31.03.2020 DE 102020204196
(43) Veröffentlichungstag der Anmeldung: 06.10.2021
(73) Patentinhaber: Bruker Switzerland AG, 8117 Fällanden (CH)
(72) Erfinder: Günter, Kenneth J., 8002 Zürich (CH); Schauwecker, Robert, 8004 Zürich (CH)
(74) Vertreter: Kohler Schmid Möbus Patentanwälte

(56) Entgegenhaltungen:
- EP-A1- 3 336 568
- US-A1- 2013 102 472
- IWASA YUKIKAZU ET AL: "Persistent-mode high-temperature superconductor shim coils: A design concept and experimental results of a prototype Z 1 high-temperature superconductor shim", APPLIED PHYSICS LETTERS, Bd. 103, Nr. 5, 29. Juli 2013 (2013-07-29) , Seite 052607, XP055805180, US ISSN: 0003-6951, DOI: 10.1063/1.4816132 Gefunden im Internet: URL:https://aip.scitation.org/doi/pdf/10.1 063/1.4816132>
- DONGKEUN PARK ET AL: "HTS Shim Coils Energized by a Flux Pump for the MIT 1.3-GHz LTS/HTS NMR Magnet: Design, Construction, and Results of a Proof-of-Concept Prototype", IEEE TRANSACTIONS ON APPLIED SUPERCONDUCTIVITY, Bd. 28, Nr. 3, 1. April 2018 (2018-04-01), Seiten 1-5, XP055687332, US ISSN: 1051-8223, DOI: 10.1109/TASC.2018.2799182

## Beschreibung

### Hintergrund der Erfindung

Die Erfindung betrifft eine Shim-Vorrichtung zur Verwendung in einer Magnetanordnung, wobei die Shim-Vorrichtung mindestens eine HTS (= Hochtemperatursupraleitermaterial) umfassende Shim-Leiterbahn und einen ersten Shim-Schalter aufweist, wobei die Shim-Leiterbahn auf einer um eine Achse gekrümmten Fläche liegt und der erste Shim-Schalter in einem ersten Leiterbahnabschnitt der Shim-Leiterbahn zur zeitweisen Unterbrechung des supraleitenden Zustandes des ersten Leiterbahnabschnittes angeordnet ist. Die Erfindung betrifft darüber hinaus eine Magnetanordnung sowie ein Verfahren zum Laden einer Shim-Vorrichtung.

### Hintergrund der Erfindung

Eine Shim-Vorrichtung und ein Verfahren zum Laden der Shim-Vorrichtung sind beispielsweise in [1], [2], [3] (nachveröffentlicht) und in [4] beschrieben.

Shim-Spulen werden zum Homogenisieren des Hauptmagnetfeldes einer Magnetanordnung eingesetzt. Dazu können insbesondere HTS-Spulen zum Einsatz kommen, da Shim-Spulen aus HTS-Material die Feldhomogenität von HTS-Hauptmagneten verbessern können, deren Betriebsfelder oder -temperaturen den Einsatz von LTS-Material für Shim-Spulen nicht erlauben. Insbesondere supraleitend geschlossene Shim-Spulen aus HTS-beschichteten Leiterbahnen haben den Vorteil, dass sie persistente Ströme tragen können, d. h. es sind kein Netzgerät und keine Stromzuleitungen zum Aufrechterhalten der elektrischen Ströme notwendig.

Aus [1] und [4] ist ein Ladeverfahren bekannt, bei dem das Laden der Shim-Spule über einen direkten Anschluss an ein Netzgerät erfolgt. Dazu wird der supraleitende Shim-Stromkreislauf unterbrochen, indem ein supraleitender Schalter geöffnet wird. Der Strom wird mit dem Netzgerät, welches parallel zum supraleitenden Schalter angeschlossen ist, direkt in den Shim-Stromkreislauf eingefahren. Nach Schließen des supraleitenden Schalters fließt der Strom im Shim-Stromkreislauf persistent und der Strom des Netzgeräts wird heruntergefahren. Persistente Shim-Spulen aus HTS-beschichteten Leiterbahnen erfordern aufgrund ihrer geringen Induktivität typischerweise deutlich größere elektrische Ströme zur Erzeugung einer gewissen Feldstärke als gewickelte Shim-Spulen mit mehreren Windungen. Das aus [1] und [4] bekannte Ladeverfahren hat daher den Nachteil, dass die entsprechend groß dimensionierten Stromzuleitungen viel Wärme von außen in den Kryostaten leiten. Außerdem erzeugen die hohen Ströme in den zumindest teilweise normalleitenden Zuleitungen während des Ladevorgangs zusätzliche Joulesche Wärme. Bei einem badgekühlten Kryostaten führt dies zu einer schnelleren Evaporation des Kryogenbades. Bei einem aktiv gekühlten Kryostaten muss ein Kryokühler mit entsprechend höherer Kühlleistung eingesetzt werden.

[5] offenbart eine Anordnung mit HTS-Shimspulen, die bei 77 K betrieben und mit einer Flusspumpe geladen werden.

Die nachveröffentlichte Patentanmeldung [3] offenbart ein induktives Ladeverfahren über eine normalleitende Ladespule, die einen Primärstromkreis bildet. Die HTS-Shim-Vorrichtung umfasst eine HTS-Shim-Leiterbahn und einen Shim-Schalter und bildet einen Sekundärstromkreis. Im Sekundärstromkreis erfolgt eine Änderung des elektrischen Stroms (Sekundärstromänderung) induktiv mittels einer Änderung des von der Ladespule erzeugten magnetischen Flusses.

Persistente HTS-Shims können aus HTS-beschichteten Folien hergestellt werden, wobei die supraleitend geschlossene Shim-Leiterbahn um eine Öffnung in der Folie verläuft. Die Shim-Leiterbahnen werden zylindrisch um die Bohrung des zu homogenisierenden Magneten gerollt. Ein HTS-Shim zur Erzeugung eines bestimmten Feldgradienten kann mit mehreren rechteckigen geschlossenen Leiterbahnen [1], [4] oder mit Leiterbahnen, welche einer nicht-konvexen Trajektorie folgen [2], realisiert werden. Die in [2] beschriebene Variante erlaubt zwar die Erzeugung komplexerer Feldverteilungen mit einer einzigen Leiterbahn, jedoch sind die Möglichkeiten im Shim-Design im HTS-Stromkreis eingeschränkt. So ist es bei den bekannten HTS-Shims aus Symmetriegründen z. B. nicht möglich, mit einer einzigen Leiterbahn einen on-axis Shim für Feldgradienten gerader Ordnung (z², z⁴, ...) ohne "Verunreinigungen" ungerader Ordnung herzustellen, da bei den bekannten Shim-Designs immer eine einseitige Stromrückführung erfolgen muss. Diese wird, um die Störungen möglichst klein zu halten, axial außerhalb durchgeführt, was jedoch dazu führt, dass die Shims eine relativ große axiale Ausdehnung aufweisen.

### Aufgabe der Erfindung

Es ist Aufgabe der Erfindung, einen persistenten HTS-Shim zur Feldhomogenisierung beispielsweise eines NMR-Magneten vorzuschlagen, der sowohl eine komplexe Feldverteilung als auch eine große Freiheit im Shim-Design ermöglicht.

### Beschreibung der Erfindung

Diese Aufgabe wird erfindungsgemäß gelöst durch eine Shim-Vorrichtung gemäß Anspruch 1, eine Magnetanordnung gemäß Anspruch 9 und ein Verfahren gemäß Anspruch 12.

Bei der erfindungsgemäßen Shim-Anordnung verläuft die Shim-Leiterbahn um mindestens eine erste Öffnung und eine zweite Öffnung, derart, dass die Shim-Leiterbahn einen ersten umlaufenden Strompfad, einen zweiten umlaufenden Strompfad und einen dritten umlaufenden Strompfad umfasst, wobei zwei der drei umlaufenden Strompfade nur je eine der Öffnungen umgeben und einer der drei umlaufenden Strompfade beide Öffnungen umgibt. Erfindungsgemäß ist der erste Leiterbahnabschnitt, in dem sich der erste Shim-Schalter befindet, Teil von nur dem ersten und dem zweiten umlaufenden Strompfad.

Bei der **Shim-Leiterbahn** handelt es sich um eine in sich geschlossene Leiter-Anordnung aus Hochtemperatursupraleitermaterial, vorzugsweise um eine HTS-Beschichtung auf einer Folie. Dabei kann es sich beispielsweise um eine Joint-freie Leiterbahnanordnung handeln. Die Shim-Leiterbahn ist im Betrieb supraleitend kurzgeschlossen, d. h. die umlaufenden Strompfade der Shim-Leiterbahn weisen (bei geschlossenem ersten Shim-Schalter) keinen elektrischen Widerstand auf. Dies wird bspw. dadurch erreicht, dass umlaufende Shim-Leiterbahnen aus HTS direkt auf eine Trägerfolie aufgebracht werden bzw. aus einer HTS-beschichteten Folie strukturiert werden.

Die Shim-Leiterbahn liegt auf einer Fläche, welche zylindrisch um die Längsachse der Shim-Vorrichtung (Achse z) gekrümmt oder "aufgerollt" ist. Die Shim-Leiterbahn verläuft also typischerweise auf einer oder mehreren Zylindermantelflächen. Bei Verwendung der Shim-Vorrichtung in einer Magnetresonanzapparatur ist die Längsachse, um welche die Fläche mit der Shim-Leiterbahn gekrümmt ist, auch die Längsachse des Hauptmagneten der Magnetresonanzapparatur.

Die erfindungsgemäße Shim-Vorrichtung kann eine oder mehrere Shim-Leiterbahnen aufweisen.

Als **Öffnungen** werden Bereiche bezeichnet, die von Teilen der Shim-Leiterbahn umgeben werden. Die Shim-Leiterbahn bildet also kontinuierliche Schleifen um zwei nicht-supraleitende Bereiche (Öffnungen), wobei jeder umlaufende Strompfad eine geometrisch geschlossene Schleife bildet. Die Öffnungen können beispielsweise als Ausstanzungen aus der beschichteten Folie oder als aus der HTS-Schicht weggeätzte oder abgetragene Bereiche ausgebildet sein.

Innerhalb einer Shim-Leiterbahn können auch mehr als drei umlaufende Strompfade und entsprechend mehr als zwei Öffnungen vorgesehen sein. Dies ermöglicht die Realisierung komplexerer Shim-Leiterbahnen.

Die umlaufenden **Strompfade** liegen in Form von im Betrieb (also nach dem Laden) supraleitend geschlossenen bzw. schließbaren Leiterbahnschleifen vor. Die umlaufenden Strompfade sind also sowohl geometrisch (umlaufend) als auch elektrisch geschlossen.

Erfindungsgemäß wird also eine Leiterbahn-Topologie vorgeschlagen, die zwei Öffnungen mit umlaufenden Strompfaden und somit Verzweigungen aufweist, wobei der erste und der zweite umlaufende Strompfad einen gemeinsamen Leiterbahnabschnitt aufweisen, der resistiv unterbrochen werden kann. Die Shim-Leiterbahn aus HTS-Material umschließt also mindestens zwei Öffnungen, so dass sich mindestens drei umlaufende Strompfade ergeben: ein umlaufender Strompfad um die erste Öffnung, ein umlaufender Strompfad um die zweite Öffnung und ein umlaufender Strompfad um beide Öffnungen. Der dritte umlaufende Strompfad umfasst nicht denjenigen Leiterbahnabschnitt, den die beiden anderen umlaufenden Strompfade gemeinsam haben.

Die erfindungsgemäße Leiterbahn-Topologie erlaubt es, Shims mit Stromtrajektorien aus einer einzigen geschlossenen Shim-Leiterbahn zu designen, welche mit einer einzigen, einfach zusammenhängenden geschlossenen Shim-Leiterbahn nicht realisierbar sind. Durch das erfindungsgemäße Vorsehen dreier umlaufender Strompfade innerhalb einer einzigen Shim-Leiterbahn stehen daher zusätzliche Freiheitsgrade beim Design von Stromtrajektorien innerhalb der Shim-Leiterbahn zur Verfügung. Es können daher eine Vielzahl an unterschiedlichen Feldgradienten oder Kombinationen von Feldgradienten erzeugt werden, insbesondere Feldgradienten ausschließlich gerader Ordnung, so dass keine unerwünschten Einflüsse aufgrund asymmetrischer Stromrückführungen den Feldgradienten verändern.

Nur der erste und der zweite umlaufende Strompfad haben den ersten Leiterbahnabschnitt, der den ersten Shim-Schalter enthält, gemeinsam, sodass der dritte umlaufende Strompfad nicht durch den ersten Shim-Schalter resistiv unterbrechbar ist. Der erste Shim-Schalter kann also gleichzeitig den ersten und den zweiten umlaufenden Strompfad resistiv unterbrechen, während der dritte umlaufende Strompfad im supraleitenden Zustand bleibt. Der dritte umlaufende Strompfad ist also im Betrieb vorzugsweise permanent supraleitend geschlossen. Dies ist insbesondere vorteilhaft für den Fall, dass der erste und zweite umlaufende Strompfad dieselbe Induktivität aufweisen und folglich um nur je eine Öffnung verlaufen, während der dritte umlaufende Strompfad um beide Öffnungen verläuft. Dann können durch ein einfaches Ladeverfahren im ersten und im zweiten umlaufenden Strompfad nämlich gleich starke elektrische Ströme mit entgegengesetztem Umlaufsinn induziert werden. Dies erlaubt die Realisierung geometrisch einfacher HTS-Shims zur Erzeugung von Feldverteilungen mit bestimmter Symmetrie.

Es sind jedoch auch Ausführungsformen denkbar, bei denen der dritte umlaufende Strompfad nur um eine Öffnung verläuft und entweder der erste oder der zweite umlaufende Strompfad um beide Öffnungen verläuft. Diese Ausführungsform kann insbesondere vorteilhaft sein für allgemeinere Formen von HTS-Shims, deren erster und zweiter umlaufende Strompfad nicht dieselbe Induktivität aufweisen.

Vorzugsweise ist die Shim-Leiterbahn in mindestens einer Lage um die Achse (z-Achse) aufgerollt und weist mindestens zwei zur Achse parallel verlaufende Leiterbahnabschnitte auf, welche radial übereinanderliegen. Nur wenn eine Shim-Leiterbahn mindestens in einer kompletten Lage um die Achse (z) aufgerollt ist, kann sie eine (bezüglich der Achse z) nahezu axialsymmetrische Feldverteilung erzeugen (on-axis Shims). Parallel zur Achse (z) verlaufende Leiterbahnabschnitte erzeugen keine axialen Magnetfeldkomponenten und tragen folglich nicht zu der gewünschten von der Shim-Leiterbahn erzeugten Feldverteilung bei. Durch das räumliche Überlagern solcher Leiterbahnabschnitte mit entgegengesetzten elektrischen Strömen kann ihr Beitrag zur Feldverteilung praktisch komplett unterdrückt werden.

Das Aufrollen der Shim-Leiterbahn in mehreren Lagen eröffnet weitere Möglichkeiten beim Shim-Design:
Spezielle Ausführungsformen sehen beispielsweise vor, dass mehrere azimutal umlaufende Leiterbahnabschnitte an unterschiedlichen axialen Positionen (bezüglich Achse z) angeordnet sind. Hiermit können insbesondere on-axis Shims zur Erzeugung von Feldgradienten gerader Ordnung realisiert werden.

Andere Ausführungsformen sehen vor, dass Leiterbahnabschnitte von in n Lagen aufgerollten Shim-Leiterbahnen in allen Lagen gleich verlaufen. In solchen Shim-Leiterbahnen ergeben sich beim induktiven Laden elektrische Ströme, welche n-mal kleiner sind als in einer Shim-Leiterbahn, welche in einer einzigen Lage mit derselben Geometrie aufgerollt ist. Die erzeugte Magnetfeldverteilung, insbesondere die Feldstärke, ist in beiden Fällen dieselbe. Eine derart in mehreren Lagen aufgerollte Shim-Leiterbahn hat daher den Vorteil, dass sie mit einer niedrigeren supraleitenden Stromtragfähigkeit ausgeführt werden kann.

Bei einer bevorzugten Ausführungsform der erfindungsgemäßen Shim-Vorrichtung verläuft die Shim-Leiterbahn symmetrisch bezüglich einer Spiegelung an einer Normalebene der Achse. Bei Verwendung der erfindungsgemäßen Shim-Vorrichtung in einer Magnetresonanzapparatur befindet sich die Normalebene typischerweise im Mittelpunkt des Hauptmagneten (z=0). Solche HTS-Shims erzeugen bezüglich der Normalebene symmetrische (gerade Ordnung) oder antisymmetrische Magnetfeldgradienten (ungerade Ordnung).

Bei einer ersten Ausführungsform dieser Art der erfindungsgemäßen Shim-Vorrichtung verlaufen der erste umlaufende Strompfad und der zweite umlaufende Strompfad bezüglich einer Spiegelung an der Normalebene der Achse je anti-symmetrisch. Unter einem anti-symmetrischen Strompfad ist ein symmetrischer Pfad mit umgekehrter Stromrichtung zu verstehen. Dies ermöglicht die Erzeugung einer asymmetrischen Feldverteilung bzgl. einer Querachse senkrecht zur Längsachse, sofern die Shim-Leiterbahn in einer einzigen Lage aufgerollt ist und der erste und zweite umlaufende Strompfad gegenläufig mit Strom durchflossen werden. Shim-Vorrichtungen mit einer solchen Feldverteilung können als off-axis-Shim (z. B. rz-Shim) eingesetzt werden.

Bei einer alternativen zweiten Ausführungsform dieser Art der erfindungsgemäßen Shim-Vorrichtung verlaufen der erste umlaufende Strompfad und der zweite umlaufende Strompfad bezüglich der Spiegelung an der Normalebene der Achse jeweils nicht anti-symmetrisch. Gemeint ist hier die Symmetrie der beiden umlaufenden Strompfade zu derselben Normalebene. Dies ermöglicht die Erzeugung einer symmetrischen Feldverteilung bzgl. der Längsachse (Feldverteilung ist symmetrisch zu einer Normalebene der Achse z bei z=0); d. h. es existieren keine Feldgradienten ungerader Ordnung (z. B. reiner z²- oder z⁴-Shim), sofern der erste und der zweite umlaufende Strompfad dieselbe Geometrie aufweisen und gegenläufig mit Strom durchflossen werden. Shim-Vorrichtungen mit einer solchen Feldverteilung können als on-axis-Shim gerader Ordnung eingesetzt werden.

Vorzugsweise weist der erste umlaufende Strompfad dieselbe Induktivität wie der zweite umlaufende Strompfad auf. Insbesondere kann dies durch Vorsehen derselben Form und derselben Abmessungen der umlaufenden Strompfade erreicht werden. Dies ermöglicht ein besonders einfaches Ladeverfahren, so dass die elektrischen Ströme in den beiden umlaufenden Strompfaden nach dem Laden gleich groß sind. Dies ist insbesondere bei Shim-Vorrichtungen von Vorteil, bei denen die Shim-Leiterbahn symmetrisch bezüglich der Spiegelung an der Normalebene der Achse verläuft, da die Symmetrie der Shim-Leiterbahn sich in der Stromverteilung und damit auch in der Feldverteilung abbildet.

Vorzugsweise ist die Shim-Leiterbahn aus einer HTS-beschichteten Folie gefertigt, welche vorzugsweise hochohmig elektrisch überbrückt ist. Als HTS-Material kommt bspw. REBCO ("Rare-Earth"-Barium-Kupferoxid), z. B. YBCO (Yttrium-Barium-Kupferoxid) oder GdBCO (Gadolinium-Barium-Kupferoxid), oder BSCCO (Bismut-Strontium-Kalzium-Kupferoxid) in Frage. Die HTS-Schicht der Shim-Leiterbahn ist typischerweise durch eine darüber liegende nur wenige µm dicke Silberschicht geschützt (hochohmig überbrückt). Im Falle eines Quenches des Hauptmagneten wird über die induktive Kopplung normalerweise auch die Shim-Leiterbahn gequencht. Mit einem genügend großen elektrischen Widerstand der überbrückenden Silberschicht wird vermieden, dass die induzierten Ströme zu einer Beschädigung der Shim-Leiterbahn führen (Quenchschutz). Zusätzlich können die beim Laden oder bei einem Quench des Hauptmagneten in der Shim-Leiterbahn induzierten Ströme reduziert werden, indem die Shim-Leiterbahn so ausgelegt wird, dass die induktiven Kopplungen zwischen den umlaufenden Strompfaden und dem Hauptmagneten möglichst klein sind.

Eine dritte Ausführungsform der erfindungsgemäßen Shim-Vorrichtung sieht vor, dass in einem weiteren Leiterbahnabschnitt ein weiterer Shim-Schalter zur zeitweisen Unterbrechung des supraleitenden Zustandes angeordnet ist, wobei der weitere Leiterbahnabschnitt Teil des dritten umlaufenden Strompfads ist. Im Falle von zwei Öffnungen kann also entweder der erste oder der zweite umlaufende Strompfad von beiden Shim-Schaltern unterbrochen werden, während die beiden anderen umlaufenden Strompfade jeweils nur von einem der Shim-Schalter unterbrochen werden können. Dies ermöglicht eine Löschung eines beim Laden des Hauptmagneten in der Shim-Leiterbahn ungewollt induzierten Stromes durch Öffnen des weiteren Shim-Schalters. Es kann auch das Prinzip einer Flusspumpe zum Laden der Shim-Leiterbahn angewandt werden. Außerdem kann durch diese Ausführungsform eine Shim-Leiterbahn realisiert werden, welche zwei verschiedene Gradienten erzeugt, deren Feldstärken beim Laden der Shim-Leiterbahn unabhängig voneinander eingestellt werden können (z. B. z-z² Hybrid-Shim, wobei ein z-Gradient vom dritten umlaufenden Strompfad und ein z²-Gradient gemeinsam vom ersten und vom zweiten umlaufenden Strompfad erzeugt wird).

Vorzugsweise dient der weitere Shim-Schalter zur Unterbrechung des beide Öffnungen umlaufenden Strompfads, während der erste Shim-Schalter so angeordnet ist, dass er nur die um je eine einzige Öffnung umlaufenden Strompfade unterbrechen kann.

Die Erfindung betrifft auch eine Magnetanordnung für eine Magnetresonanzapparatur, wobei die Magnetanordnung umfasst:
- einen Kryostaten mit einer Raumtemperaturbohrung,
- ein im Kryostaten angeordnetes supraleitendes Magnetspulensystem mit
   ∘ einem Hauptmagneten zur Erzeugung eines Magnetfeldes in Richtung einer Achse in einem Arbeitsvolumen, durch das die Achse verläuft und
   ∘ eine Shim-Vorrichtung gemäß einem der vorhergehenden Ansprüche zum Einstellen des räumlichen Verlaufs und/oder zur räumlichen Homogenisierung eines vom Hauptmagneten im Arbeitsvolumen erzeugten Magnetfeldes,
- und eine Ladevorrichtung mit mindestens einer Ladespule, welche dazu eingerichtet ist, mit der mindestens einen Shim-Leiterbahn der Shim-Vorrichtung induktiv zu koppeln.

Die erfindungsgemäße Magnetanordnung ist vorzugsweise dazu eingerichtet, dass die Shim-Vorrichtung gemäß dem unten beschriebenen Verfahren geladen werden kann.

Das Arbeitsvolumen der Magnetanordnung ist um einen auf der Längsachse des Hauptmagneten liegenden Punkt angeordnet. Die Shim-Leiterbahn der Shim-Vorrichtung ist bezüglich der Längsachse des Hauptmagneten radial mindestens teilweise innerhalb des Hauptmagneten angeordnet. Die Längsachse des Hauptmagneten ist vorzugsweise identisch mit der Achse der Shim-Vorrichtung (z-Achse), um die herum die Shim-Leiterbahn angeordnet ist.

Die Shim-Leiterbahn erzeugt im Betrieb ein Magnetfeld mit einer axialen Komponente bezüglich eines Zylinderkoordinatensystems um die z-Achse.

Die Ladevorrichtung umfasst vorzugsweise eine normalleitende Ladespule, eine Energieversorgung und Zuleitungen, welche zusammen mindestens einen Primärstromkreis bilden, wobei die Ladespule in der Raumtemperaturbohrung des Kryostaten angeordnet ist oder temporär angeordnet werden kann. Über den Primärstromkreis kann die Shim-Leiterbahn als Sekundärstromkreis induktiv geladen werden.

Vorzugsweise koppelt die Ladespule während des Ladevorgangs unterschiedlich stark mit dem ersten umlaufenden Strompfad und dem zweiten umlaufenden Strompfad induktiv. Dies kann beispielsweise erreicht werden, indem die Ladespule axial und/oder radial von dem ersten umlaufenden Strompfad unterschiedlich weit entfernt ist als von dem zweiten umlaufenden Strompfad. Dies ist wichtig für eine Shim-Leiterbahn, deren erster umlaufender Strompfad dieselbe Induktivität aufweist wie der zweite umlaufende Strompfad. In diesem Fall kann hierdurch sichergestellt werden, dass bei geschlossenem ersten Shim-Schalter der erste und der zweite umlaufende Strompfad unterschiedlich von der Ladespule beeinflusst werden. Auf diese Weise wird erreicht, dass nach dem Herunterfahren des Stroms in der Ladespule (dritte Phase) ein Strom innerhalb der Shim-Leiterbahn verbleibt.

Vorzugsweise ist die Ladespule während des Ladevorgangs nahe an einem axialen Ende der Shim-Vorrichtung angeordnet.

Bei einer speziellen Ausführungsform der erfindungsgemäßen Magnetanordnung koppeln verschiedene umlaufende Strompfade mit derselben Ladespule induktiv. Dies kann durch eine geeignete Auslegung oder Positionierung der Ladespule relativ zu den umlaufenden Strompfaden erreicht werden und hat z. B. den Vorteil, dass verschiedene Shim-Leiterbahnen über eine einzige Ladespule geladen werden können. Alternativ können verschiedene Shim-Leiterbahnen über unterschiedliche Ladespulen mit entsprechend optimierten induktiven Kopplungen geladen werden.

Die Erfindung betrifft auch ein Verfahren zum Laden einer zuvor beschriebenen Shim-Vorrichtung in einer zuvor beschriebenen Magnetanordnung, wobei eine Änderung des elektrischen Stroms in der Shim-Leiterbahn induktiv mittels einer Änderung eines von der Ladespule erzeugten magnetischen Flusses durch die von der Shim-Leiterbahn eingeschlossene Fläche erfolgt, wobei
I. in einer ersten Phase in beliebiger Reihenfolge der erste Shim-Schalter zur Unterbrechung des supraleitenden Zustandes mindestens zeitweise geöffnet wird, und mittels einer Stromänderung in der Ladespule oder durch Bewegung der Ladespule eine elektrische Stromänderung in mindestens einem der umlaufenden Strompfade induziert wird,
II. in einer zweiten Phase durch Schließen des ersten Shim-Schalters zwei der umlaufenden Strompfade supraleitend geschlossen werden; und
III. in einer dritten Phase bei geschlossenem ersten Shim-Schalter mittels einer Stromänderung in der Ladespule oder durch Bewegung der Ladespule elektrische Stromänderungen in den umlaufenden Strompfaden induziert werden.

Durch das Laden mittels Induktion kann auf Stromzuleitungen zu der Shim-Leiterbahn verzichtet werden. Die Ladespule ist vorzugsweise so angeordnet, dass die umlaufenden Strompfade, die nur um eine Öffnung verlaufen, nicht gleichermaßen induktiv mit der Ladespule koppeln. Dies ist insbesondere interessant für die Anordnungen, bei denen der erste und der zweite umlaufende Strompfad dieselbe Form und dieselben Abmessungen (und folglich dieselbe Induktivität) aufweisen.

In der ersten Phase wird eine Änderung des elektrischen Stroms in der Ladespule vorgenommen. Falls keine stationäre Ladespule in der Raumtemperaturbohrung vorgesehen ist, wird zudem die Ladespule in der Raumtemperaturbohrung des Kryostaten positioniert (vor oder nach Stromänderung in der Ladespule). Nach der ersten Phase sind der erste und der zweite umlaufende Strompfad resistiv unterbrochen und es fließt im dritten geschlossenen umlaufenden Strompfad ein effektiver induzierter Strom (unter der Annahme, dass vor der ersten Phase der dritte umlaufende Strompfad vollständig entladen war).

In der zweiten Phase wird der erste Shim-Schalter geschlossen. Nach der zweiten Phase sind der erste und der zweite umlaufende Strompfad also supraleitend geschlossen. Aufgrund der Flusserhaltung ändern sich die elektrischen Ströme in der Shim-Leiterbahn hierbei nicht.

In der dritten Phase wird bei geschlossenem ersten Shim-Schalter der elektrische Strom in der Ladespule verändert und/oder die Ladespule wird aus der Raumtemperaturbohrung entfernt. Die dadurch entstehende Flussänderung beeinflusst den ersten und den zweiten umlaufenden Strompfad i.A. unterschiedlich, so dass in ihnen nach dem Ladevorgang Ströme mit unterschiedlichen Stromstärken und/oder Umlaufsinn fließen.

Vorzugsweise ist die Stromänderung in der Ladespule in der dritten Phase gleich groß wie die Stromänderung in der Ladespule in der ersten Phase, jedoch mit umgekehrtem Vorzeichen. Wenn die Ladespule anfangs des Ladeverfahrens keinen Strom trägt, ist ihr Strom somit auch am Ende des Ladeverfahrens gleich Null. Dies hat den Vorteil, dass die Ladespule vor und nach dem Ladeverfahren bei der Shim-Leiterbahn positioniert bzw. wieder von ihr entfernt werden kann, ohne dass dies zu zusätzlichen Flussänderungen in der Shim-Leiterbahn führt.

Bei einer speziellen Variante des erfindungsgemäßen Verfahrens bleibt der dritte umlaufende Strompfad während des Ladevorgangs supraleitend geschlossen.

Eine spezielle Variante des erfindungsgemäßen Verfahrens betrifft ein Verfahren zum Laden einer Shim-Vorrichtung mit einem weiteren Shim-Schalter zur zeitweisen Unterbrechung des supraleitenden Zustandes in einem vom ersten Leiterbahnabschnitt verschiedenen weiteren Leiterbahnabschnitt der Shim-Leiterbahn.

Dabei werden zusätzlich zu den zuvor beschriebenen drei Phasen in der ersten Phase drei weitere Verfahrensschritte durchgeführt: 1. der weitere Shim-Schalter zur Unterbrechung des supraleitenden Zustandes des weiteren Leiterbahnabschnitts wird mindestens einmal geöffnet; 2. Mittels einer Stromänderung in der Ladespule oder durch Bewegung der Ladespule werden weitere elektrische Stromänderungen in den umlaufenden Strompfaden induziert; 3. Der weitere Shim-Schalter wird geschlossen. Diese drei Schritte werden in der bereits oben beschriebenen ersten Phase enthaltenen Stromänderung in der Ladespule oder Bewegung der Ladespule durchgeführt.

Durch das Öffnen der Shim-Schalter in der ersten Phase wird der zuvor in den umlaufenden Strompfaden vorhandene Strom auf Null gesetzt. In dieser Phase können der erste und der weitere Shim-Schalter im Prinzip beliebig oft geöffnet und geschlossen werden. Wichtig ist lediglich, dass der weitere Shim-Schalter während und nach der zweiten beschriebenen Stromänderung in der ersten Phase geschlossen bleibt und der erste Shim-Schalter während und nach der Stromänderung in der dritten Phase geschlossen ist.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt eine perspektivische Ansicht einer ersten Ausführungsform einer erfindungsgemäßen Shim-Vorrichtung, bei welcher der erste umlaufende Strompfad und der zweite umlaufende Strompfad bezüglich der Spiegelung an der Normalebene der Achse (z) anti-symmetrisch verlaufen.
- Fig. 2: zeigt eine Abwicklungsdarstellung der Shim-Vorrichtung aus Fig. 1.
- Fig. 3: zeigt eine perspektivische Ansicht einer zweiten Ausführungsform einer erfindungsgemäßen Shim-Vorrichtung, bei welcher der erste umlaufende Strompfad und der zweite umlaufende Strompfad bezüglich der Spiegelung an der Normalebene der Achse (z) nicht anti-symmetrisch verlaufen.
- Fig. 4: zeigt eine Abwicklungsdarstellung der Shim-Vorrichtung aus Fig. 3.
- Fig. 5: zeigt eine Abwicklungsdarstellung einer dritten Ausführungsform einer erfindungsgemäßen Shim-Vorrichtung mit einem weiteren supraleitenden Shim-Schalter.
- Fig. 6: zeigt eine erfindungsgemäße Magnetanordnung.
- Fig. 7: zeigt die verschiedenen Verfahrensphasen einer ersten Variante des erfindungsgemäßen Verfahrens unter Verwendung einer Shim-Vorrichtung mit erstem supraleitenden Shim-Schalter im ersten und zweiten umlaufenden Strompfad, welche nur um je eine Öffnung verlaufen.
- Fig. 8: zeigt die verschiedenen Verfahrensphasen einer ersten Variante des erfindungsgemäßen Verfahrens unter Verwendung einer Shim-Vorrichtung mit erstem supraleitenden Shim-Schalter im ersten und zweiten umlaufenden Strompfad, wobei der erste umlaufende Strompfad um beide Öffnungen verläuft.
- Fig. 9: zeigt die verschiedenen Verfahrensphasen einer ersten Variante des erfindungsgemäßen Verfahrens unter Verwendung einer Shim-Vorrichtung mit zwei supraleitenden Shim-Schaltern.

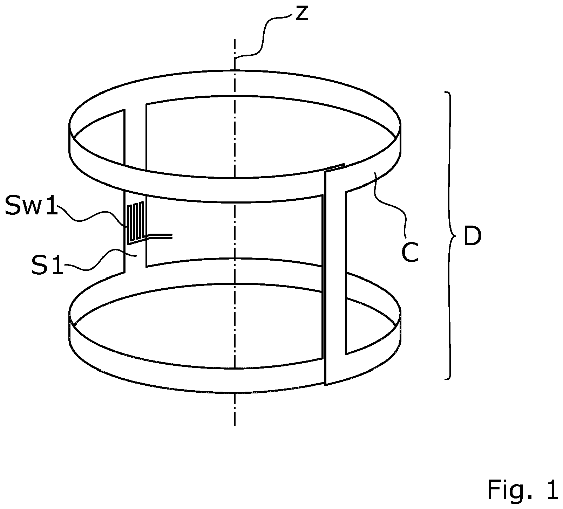

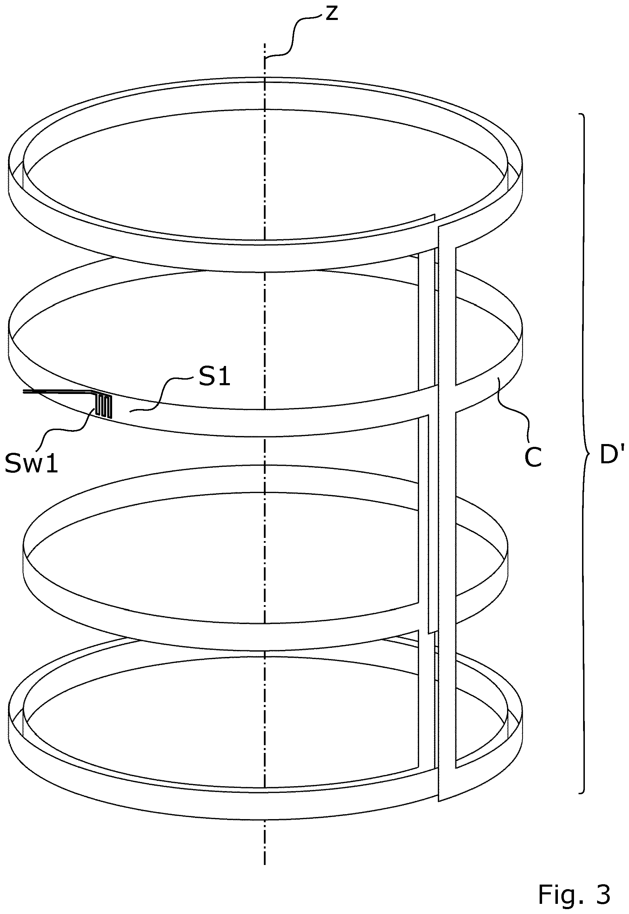

In den Fig. 1 - 5 sind verschiedene Ausführungsformen der erfindungsgemäßen Shim-Vorrichtung **D, D', D"** gezeigt. Die erfindungsgemäße Shim-Vorrichtung D, D', D" umfasst eine Shim-Leiterbahn **C** aus HTS-Material, die sich auf einer Zylinderoberfläche um eine Achse **z** erstreckt, wie in **Fig. 1** und **Fig. 3** dargestellt. Die Shim-Leiterbahn C umgibt dabei die Achse z vollständig, ist also mindestens einmal um die Achse z "aufgewickelt". Die Shim-Leiterbahn C weist einen ersten umlaufenden Strompfad **L1** um eine erste Öffnung **O1** und einen zweiten umlaufenden Strompfad **L2** um eine zweite Öffnung **O2** auf. Ein dritter umlaufender Strompfad **L3** verläuft um beide Öffnungen O1, O2. Die umlaufenden Strompfade L1, L2, L3 werden aus Leiterbahnabschnitten der Shim-Leiterbahn C (schraffiert dargestellt) gebildet. Der Übersichtlichkeit halber sind die Verläufe der umlaufenden Strompfade L1, L2, L3 gestrichelt seitlich versetzt zu den entsprechenden Leiterbahnabschnitten eingezeichnet. In einem ersten Leiterbahnabschnitt S1 ist ein erster Shim-Schalter **Sw1** angeordnet, der den supraleitenden Zustand des ersten Leiterbahnabschnitts S1 unterbrechen kann. Der erste umlaufende Strompfad L1 und der zweite umlaufende Strompfad L2 haben einen ersten Leiterbahnabschnitt **S1** gemeinsam.

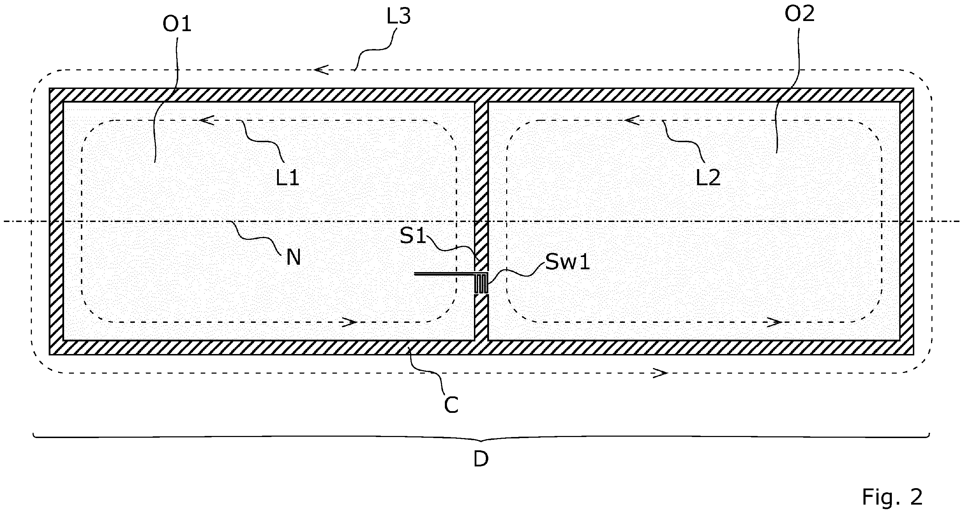

**Fig. 1** zeigt eine perspektivische Ansicht, **Fig. 2** eine Abwicklungsdarstellung, einer ersten Ausführungsform einer erfindungsgemäßen Shim-Vorrichtung D. Bei der in Fig. 1 und Fig. 2 gezeigten Ausführungsform weisen sowohl die Shim-Leiterbahn C insgesamt als auch die einzelnen umlaufenden Strompfade L1, L2, L3 eine Symmetrie bzw. Anti-Symmetrie bezüglich einer Spiegelung an einer Normalebene **N** der Achse z auf. Die Shim-Leiterbahn C verläuft dazu einmal komplett um die Achse z, wobei sich die parallel zur Achse z verlaufenden Leiterbahn-Endabschnitte in radialer Richtung überlappen, wie in Fig. 1 dargestellt. Bei der in Fig. 1 und Fig. 2 gezeigten Ausführungsform befindet sich der erste Shim-Schalter Sw1 im ersten Leiterbahnabschnitt S1, der Teil des ersten umlaufenden Strompfads L1 und des zweiten umlaufenden Strompfads L2 ist, wobei der erste und der zweite umlaufende Strompfad um nur je eine der beiden Öffnungen O1, O2 verlaufen. Der erste Shim-Schalter Sw1 könnte auch in einem anderen Leiterbahnabschnitt angeordnet sein, sodass entweder der erste oder der zweite umlaufende Strompfad um beide Öffnungen O1, O2 verläuft.

Bei der in den Fig. 1 und 2 gezeigten speziellen Topologie tragen alle azimutal verlaufenden Leiterbahnabschnitte zum gewünschten on-axis Feld bei. Es existieren keine unerwünschten Störungen durch Stromrückführungen. Daher kann die komplette Shim-Leiterbahn C eine geringe axiale Ausdehnung aufweisen, so dass besonders kompakte Shim-Leiterbahnen C aus relativ schmalen HTS-Folien realisiert werden können.

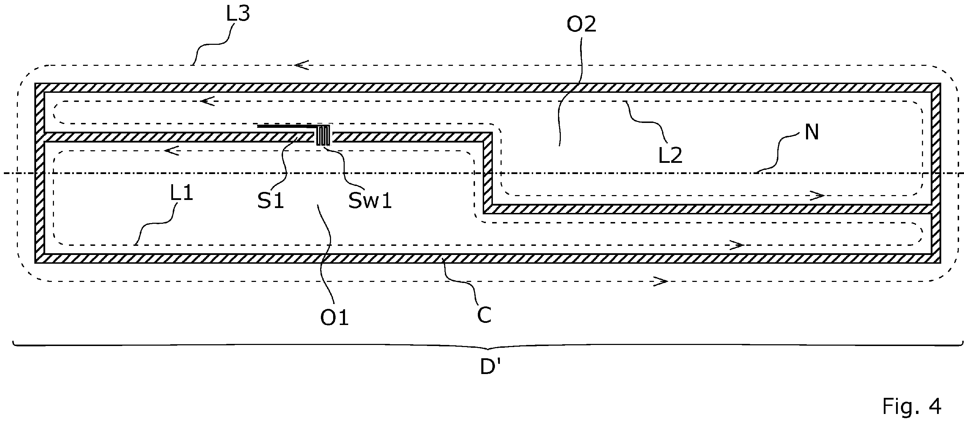

**Fig. 3** zeigt eine perspektivische Ansicht, **Fig. 4** die dazugehörige Abwicklungsdarstellung, einer zweiten Ausführungsform der erfindungsgemäßen Shim-Vorrichtung D', bei der zwar die Shim-Leiterbahn C symmetrisch zu einer Normalebene N der Achse z ist, der erste umlaufende Strompfad L1 und der zweite umlaufende Strompfad L2 jedoch keine Anti-Symmetrie bezüglich einer Spiegelung an der Normalebene N der Achse z aufweist. Die Symmetrie der Shim-Leiterbahn C ergibt sich dadurch, dass die Shim-Leiterbahn zweimal komplett um die Achse z verläuft, wobei sich die parallel zur Achse z verlaufenden Leiterbahn-Endabschnitte sowie ein parallel zur Achse z verlaufender Leiterbahn-Mittelabschnitt in radialer Richtung überlappen, wie in Fig. 3 dargestellt. Bei der in Fig. 3 und Fig. 4 gezeigten Ausführungsform befindet sich der erste Shim-Schalter Sw1 im ersten Leiterbahnabschnitt S1, der Teil des ersten umlaufenden Strompfads L1 und des zweiten umlaufenden Strompfads L2 ist, wobei der erste und der zweite umlaufende Strompfad um nur je eine der beiden Öffnungen O1, O2 verlaufen. Der erste Shim-Schalter Sw1 könnte auch in einem anderen Leiterbahnabschnitt angeordnet sein, sodass entweder der erste oder der zweite umlaufende Strompfad um beide Öffnungen O1, O2 verläuft.

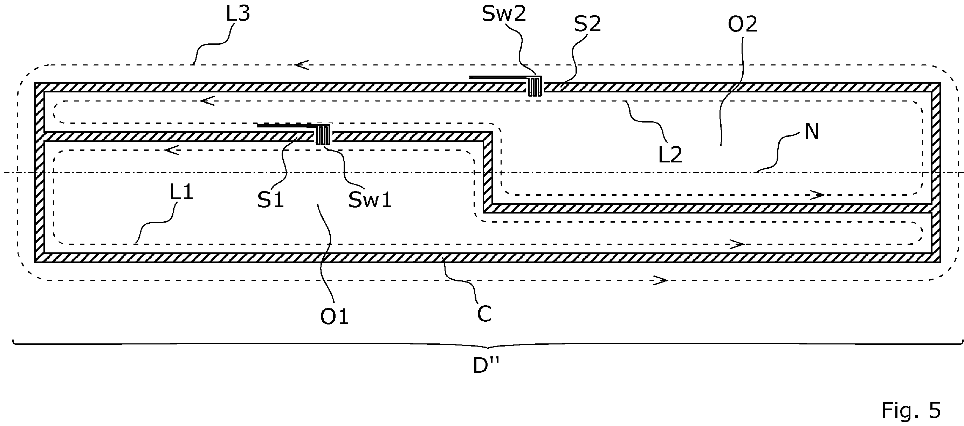

**Fig. 5** zeigt eine Abwicklungsdarstellung einer weiteren Ausführungsform der erfindungsgemäßen Shim-Vorrichtung D", bei der zwar die Shim-Leiterbahn C symmetrisch zu der Normalebene N der Achse z ist, der erste umlaufende Strompfad L1 und der zweite umlaufende Strompfad L2 jedoch keine Anti-Symmetrie bezüglich einer Spiegelung an einer Normalebene N der Achse z aufweisen (analog zu der in Fig. 3 und 4 gezeigten Ausführungsform). Zusätzlich zu dem im ersten Leiterbahnabschnitt S1 angeordneten ersten Shim-Schalter Sw1 umfasst die Shim-Vorrichtung aus Fig. 5 einen weiteren Shim-Schalter Sw2 in einem weiteren Leiterbahnabschnitt S2. Beide Leiterbahnabschnitte S1, S2 sind im zweiten umlaufenden Strompfad L2 angeordnet. Sie unterscheiden sich dadurch, dass der erste Shim-Schalter Sw1 im ersten umlaufenden Strompfad L1 und der weitere Shim-Schalter Sw2 im dritten umlaufenden Strompfad L3 angeordnet ist.

Mit den in den Fig. 3 - 5 gezeigten Ausführungsformen können Feldverteilungen erzeugt werden, die bezüglich der Normalebene N (im Magnetzentrum) rein symmetrisch sind, d. h. in axialer Richtung keine Feldgradienten ungerader Ordnung enthalten.

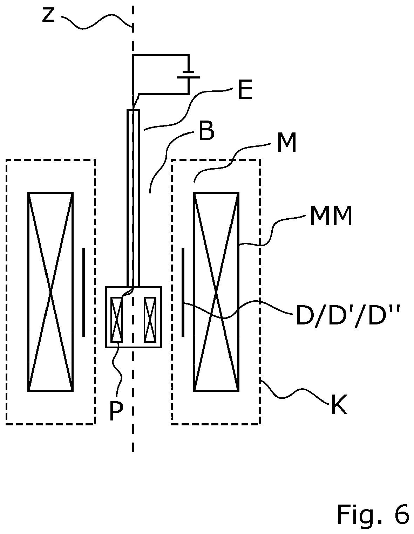

**Fig. 6** zeigt eine erfindungsgemäße Magnetanordnung. Sie umfasst einen Kryostaten **K** mit einer Raumtemperaturbohrung **B.** Im Kryostaten K befindet sich ein Magnetspulensystem **M** mit einem Hauptmagneten **MM** zur Erzeugung eines Hauptmagnetfeldes mit einer Hauptmagnet-Längsachse identisch zur Achse der Shim-Vorrichtung (z-Achse), um die herum die Shim-Leiterbahn angeordnet ist, und mit einer erfindungsgemäßen Shim-Vorrichtung **D, D', D"** zur Anpassung oder Homogenisierung des Hauptmagnetfeldes. Zum Laden der Shim-Vorrichtung D, D', D" ist eine Ladevorrichtung **E** vorgesehen, mittels der die Shim-Vorrichtung D, D', D" induktiv geladen werden kann. Die Ladevorrichtung E umfasst eine Ladespule **P,** die über Zuleitungen durch eine Energieversorgung bestromt werden kann. Die Ladespule P ist für den Ladevorgang innerhalb der Raumtemperaturbohrung B angeordnet, so dass die Ladespule P optimal mit der Shim-Leiterbahn C koppeln kann. Der Ladevorgang der Shim-Vorrichtung D, D', D" erfolgt induktiv.

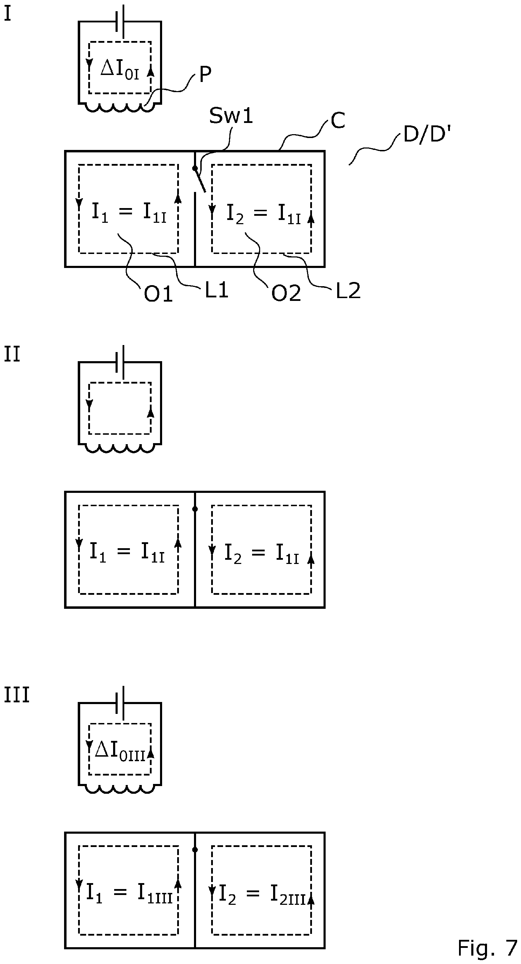

In Fig. 7 - 9 sind die verschiedenen Phasen für verschiedene Verfahrensvarianten schematisch dargestellt. Dabei sind für die verschiedenen Phasen I, II, III die elektrischen Ströme in der Ladevorrichtung E, sowie für den ersten und zweiten umlaufenden Strompfad L1, L2 dargestellt. Die Pfeilrichtung definiert jeweils die Richtung positiven Stroms. Für Leiterbahnabschnitte, die sowohl Teil des ersten umlaufenden Strompfads L1 als auch des zweiten umlaufenden Strompfads L2 sind, sind die elektrischen Ströme der jeweiligen umlaufenden Strompfade dargestellt. Der real in dem entsprechenden Leiterbahnabschnitt fließende Strom ergibt sich durch Überlagerung der in den Figuren für die gemeinsamen Leiterbahnabschnitte eingezeichneten Ströme.

Da bei einer Shim-Leiterbahn C mit einem einzigen (ersten) Shim-Schalter Sw1 der dritte umlaufende Strompfad während des Ladeverfahrens (Phasen I - III) nicht unterbrochen wird, bleibt der magnetische Fluss durch seine Fläche unverändert bei Null. Folglich fliessen die elektrischen Ströme im ersten und zweiten umlaufenden Strompfad nach dem Laden in derselben Richtung über den geschlossenen Shim-Schalter Sw1, bevor sie sich über eine Verzweigung aufteilen.

**Fig. 7** zeigt schematisch die verschiedenen Verfahrensphasen **I, II, III** einer ersten Variante des erfindungsgemäßen Verfahrens unter Verwendung einer Shim-Vorrichtung D/D' mit erstem Shim-Schalter Sw1 im gemeinsamen ersten Leiterbahnabschnitt des ersten und zweiten umlaufenden Strompfads L1, L2. Der erste umlaufende Strompfad L1 verläuft nur um die erste Öffnung O1, der zweite umlaufende Strompfad verläuft nur um die zweite Öffnung O2.

In der ersten Phase I ist der erste Shim-Schalter Sw1 zur Unterbrechung des supraleitenden Zustandes mindestens zeitweise geöffnet. In der Ladespule P wird eine elektrische Stromänderung ΔI_{0I} bewirkt oder die bestromte Ladespule P wird relativ zur Shim-Vorrichtung D/D' bewegt. Dadurch wird eine elektrische Stromänderung in der Shim-Leiterbahn C induziert.

Für den Fall, dass der erste Schalter Sw1 während der Stromänderung geöffnet ist, ist der effektive Strom im ersten Leiterbahnabschnitt S1, der sowohl Teil des ersten umlaufenden Strompfads L1 als auch des zweiten umlaufenden Strompfads L2 ist, aufgrund des geöffneten ersten Shim-Schalters Sw1 gleich Null. Daraus ergibt sich für den elektrischen Strom im ersten umlaufenden Strompfad I₁ der gleiche Wert I_{1I} wie für den elektrischen Strom im zweiten umlaufenden Strompfad I₂.

Für den Fall, dass der erste Shim-Schalter Sw1 während der Stromänderung geschlossen ist und nach der Stromänderung geöffnet wird, ergibt sich für den Strom im ersten umlaufenden Strompfad I₁ ebenfalls der gleiche Wert I_{1I} wie für den Strom im zweiten umlaufenden Strompfad I₂.

Nach der ersten Phase I sind der erste und der zweite umlaufende Strompfad L1, L2 resistiv unterbrochen.

In der zweiten Phase II wird der erste Shim-Schalter Sw1 und somit der erste und der zweite umlaufende Strompfad L1, L2 supraleitend geschlossen. Aufgrund der Flusserhaltung wird keine Änderung des Stromflusses innerhalb der Shim-Leiterbahn C bewirkt.

In der dritten Phase III wird bei geschlossenem ersten Shim-Schalter Sw1 mittels einer elektrischen Stromänderung ΔI_{0III} in der Ladespule P oder durch Bewegung der Ladespule P (nicht gezeigt) eine elektrische Stromänderung in den umlaufenden Strompfaden L1, L2, L3 induziert. Da die Ladespule P den ersten umlaufenden Strompfad L1 anders beeinflusst als den zweiten umlaufenden Strompfad L2 (je nachdem wo die Ladespule P angeordnet ist und welche Induktivitäten und induktive Kopplung der erste und zweite umlaufende Strompfad L1, L2 aufweisen), wird im ersten umlaufenden Strompfad L1 eine Stromänderung von I_{1I} auf 1_{1III} bewirkt, wohingegen im zweiten umlaufenden Strompfad L2 eine Stromänderung von I_{1I} auf I_{2III} bewirkt wird. Es ergibt sich dadurch ein resultierender Strom im gemeinsamen ersten Leiterbahnabschnitt S1.

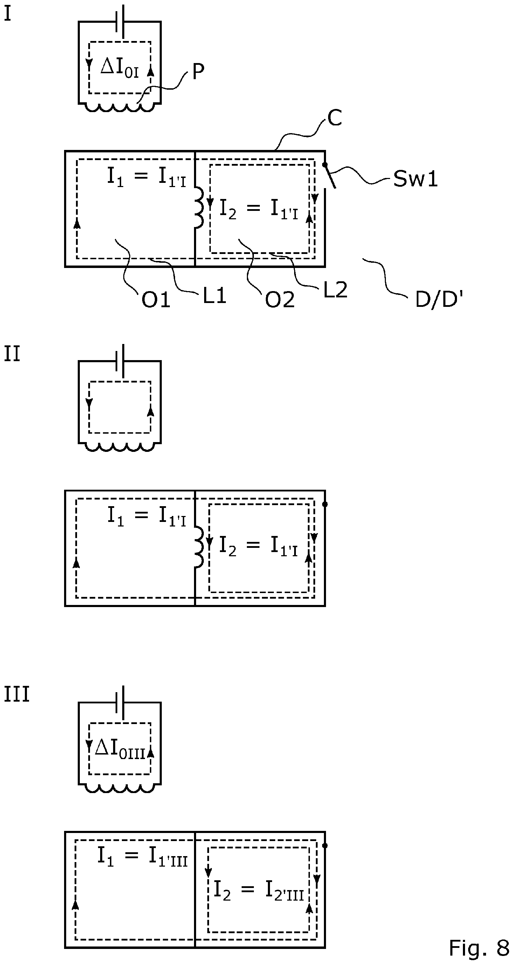

In **Fig. 8** sind die Phasen I, II, III analog zu Fig. 7 für eine Variante schematisch dargestellt, bei der der erste umlaufende Strompfad L1 sowohl um die erste Öffnung O1 als auch um die zweite Öffnung O2 verläuft, da der erste Leiterbahnabschnitt S1 mit dem ersten Shim-Schalter Sw1 nun anders als in Fig. 7 angeordnet ist.

In der ersten Phase I ist der erste Shim-Schalter Sw1 zur Unterbrechung des supraleitenden Zustandes mindestens zeitweise geöffnet. In der Ladespule P wird eine elektrische Stromänderung ΔI_{0I} bewirkt oder die bestromte Ladespule P wird relativ zur Shim-Vorrichtung D/D' bewegt. Dadurch wird eine elektrische Stromänderung in der Shim-Leiterbahn C induziert.

Für den Fall, dass der erste Shim-Schalter Sw1 während der Stromänderung geöffnet ist, ist der effektive Strom im ersten Leiterbahnabschnitt, der sowohl Teil des ersten umlaufenden Strompfads L1 als auch des zweiten umlaufenden Strompfads L2 ist, aufgrund des geöffneten ersten Shim-Schalters Sw1 gleich Null. Somit werden im ersten umlaufenden Strompfad L1 und im zweiten umlaufenden Strompfad L2 gleich starke Ströme I₁=I_{1'I} und I₂=I_{1'I} induziert..

Für den Fall, dass der erste Shim-Schalter Sw1 während der Stromänderung geschlossen ist und nach der Stromänderung geöffnet wird, ergeben sich für die elektrischen Ströme im ersten und im zweiten umlaufenden Strompfad ebenfalls I₁ = I₂ = I_{1'I}.

Nach der ersten Phase I sind der erste und der zweite umlaufende Strompfad L1, L2 resistiv unterbrochen.

In der zweiten Phase II wird der erste Shim-Schalter Sw1 und somit der erste und der zweite umlaufende Strompfad L1, L2 supraleitend geschlossen. Aufgrund der Flusserhaltung wird keine Änderung des Stromflusses innerhalb der Shim-Leiterbahn C bewirkt.

In der dritten Phase III wird bei geschlossenem ersten Shim-Schalter Sw1 mittels einer Stromänderung ΔI_{0III} in der Ladespule P oder durch Bewegung der Ladespule P (nicht gezeigt) eine elektrische Stromänderung in den umlaufenden Strompfaden L1, L2, L3 induziert. Da die Ladespule P den ersten umlaufenden Strompfad L1 anders beeinflusst als den zweiten umlaufenden Strompfad L2 (je nachdem wo die Ladespule P angeordnet ist und welche Induktivitäten und induktive Kopplung der erste und zweite umlaufende Strompfad L1, L2 aufweisen), wird im ersten umlaufenden Strompfad L1 eine Stromänderung von I_{1'I} auf I_{1'III} bewirkt, wohingegen im zweiten umlaufenden Strompfad L2 eine Stromänderung von I_{1'I} auf I_{2'III} bewirkt wird.

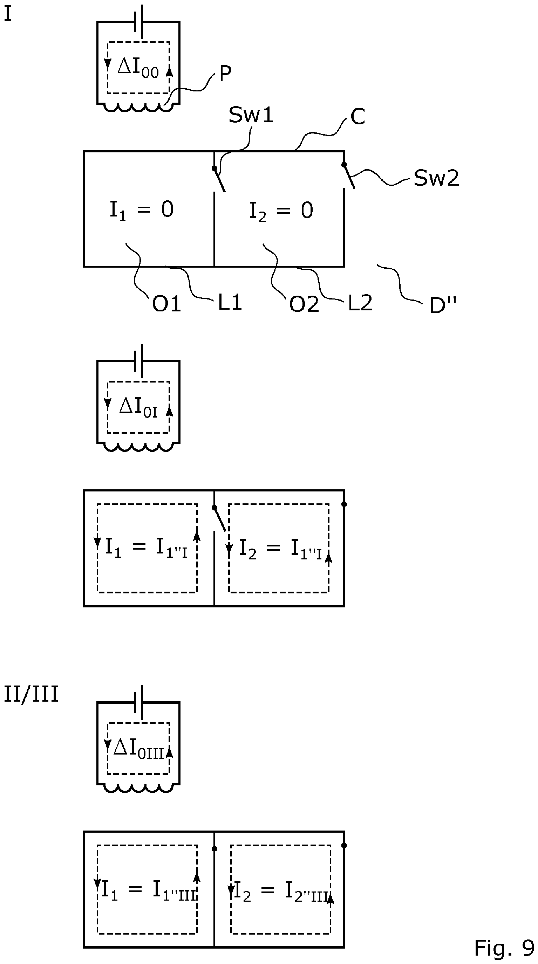

In **Fig. 9** ist ein Beispiel einer Verfahrensvariante für eine Shim-Vorrichtung D" mit zwei Shim-Schaltern Sw1, Sw2 schematisch dargestellt. Zusätzlich zu den Verfahrensschritten in den zuvor beschriebenen Phasen I - III werden in der ersten Phase I weitere Schritte durchgeführt. So wird in der Ladespule P eine Stromänderung ΔI₀₀ bewirkt. Vor oder nach dieser Bestromung der Ladespule P werden die Shim-Schalter Sw1, Sw2 geöffnet. Dies hat den Effekt, dass unabhängig von der Bestromung der Ladespule P die umlaufenden Strompfade L1, L2, L3 danach stromfrei sind. Damit wird es beispielsweise ermöglicht, die Stromstärke der Ladespule P in der ersten Phase I so zu wählen, dass am Ende des Ladeverfahrens der Strom in der Ladespule P Null ist, so dass die Ladespule P aus der Shim-Vorrichtung D" entfernt werden kann, ohne unerwünschte Ströme zu induzieren.

Im weiteren Verlauf der ersten Phase I wird zunächst der weitere Shim-Schalter Sw2 geschlossen, worauf der Strom in der Ladespule P auf einen zuvor festgelegten Wert I_{0I} eingestellt wird. Dies induziert im ersten und im zweiten umlaufenden Strompfad L1 und L2 (oder äquivalent im dritten umlaufenden Strompfad L3) einen Strom I_{1"I}. In dem in Fig. 9 gezeigten Beispiel verlaufen der erste und der zweite umlaufende Strompfad L1, L2 um nur je eine der beiden Öffnungen O1, O2. Das weitere Verfahren erfolgt daher analog zu den Phasen II und III in Fig. 7.

Die mit Hilfe von Fig. 9 beschriebene Verfahrensvariante ist auch möglich, wenn die Positionen der beiden Shim-Schalter Sw1, Sw2 vertauscht werden. Das weitere Verfahren erfolgt dann analog zu Fig. 8.

Bei allen Varianten des erfindungsgemäßen Verfahrens mit einem einzigen (ersten) Shim-Schalter Sw1 ist nach dem Laden der erfindungsgemäßen Shim-Vorrichtung D, D' das Verhältnis der beiden Stromstärken im ersten umlaufenden Strompfaden L1 und im zweiten umlaufenden Strompfad L2 allein durch die Induktivitäten und die induktive Kopplung der beiden umlaufenden Strompfade L1, L2 gegeben und ist unabhängig von der fixen räumlichen Positionierung der Ladespule P, solange die Stromänderung der Ladespule P in der dritten Phase III gleich der negativen Stromänderung in der ersten Phase I ist. Das erfindungsgemäße Verfahren ermöglicht die Erzeugung von klar definierten Feldverteilungen mit einer einzigen Shim-Leiterbahn C.

Im Gegensatz zur Erzeugung derartiger Stromtrajektorien mit zwei unabhängigen Shim-Leiterbahnen C mit je einer Öffnung, ist das Stromverhältnis zwischen den beiden Strompfaden L1, L2 und folglich die erzeugte Feldverteilung aber mit dem erfindungsgemäßen Verfahren genau kontrollierbar, da hier weder eine Abhängigkeit von der relativen Position der Ladespule P (bzw. von den induktiven Kopplungen zwischen den umlaufenden Strompfaden L1, L2 und der Ladespule P) noch von der Genauigkeit der Stromänderungen in der Ladespule P besteht.

### Bezugszeichenliste

- C: Shim-Leiterbahn
- D, D', D": Shim-Vorrichtung
- E: Ladevorrichtung
- K: Kryostat
- L1: erster umlaufender Strompfad
- L2: zweiter umlaufender Strompfad
- L3: dritter umlaufender Strompfad
- M: Magnetspulensystem
- MM: Hauptmagnet
- N: Normalebene
- O1: erste Öffnung
- O2: zweite Öffnung
- P: Ladespule
- S1: erster Leiterbahnabschnitt
- S2: weiterer Leiterbahnabschnitt
- Sw1: erster Shim-Schalter im ersten Leiterbahnabschnitt
- Sw2: weiterer Shim-Schalter im weiteren Leiterbahnabschnitt
- z: Achse
- I: erste Phase
- II: zweite Phase
- III: dritte Phase
- I₁: Strom im ersten umlaufenden Strompfad
- I₂: Strom im zweiten umlaufenden Strompfad

### Literaturliste

[1] US 8,965,468 B2 (Iwasa)
[2] DE 10 2016 225 017 A1 (Bruker BioSpin AG)
[3] DE 10 2018 221 322 A1
[4] IWASA, Yukikazu, et al.
   Persistent-mode high-temperature superconductor shim coils: A design concept and experimental results of a prototype Z1 high-temperature superconductor shim.
   Applied physics letters, 2013, 103. Jg., Nr. 5, S. 052607.
[5] PARK, Dongkeun, et al.
   HTS shim coils energized by a flux pump for the MIT 1.3-GHz LTS/HTS NMR magnet: Design, construction, and results of a proof-of-concept prototype. IEEE Transactions an Applied Superconductivity, 2018, 28. Jg., Nr. 3, S. 1-5

## Patentansprüche

1. Shim-Vorrichtung (D; D'; D") zur Verwendung in einer Magnetanordnung (M), wobei die Shim-Vorrichtung (D; D'; D") mindestens eine HTS (= Hochtemperatursupraleitermaterial umfassende) Shim-Leiterbahn (C) und einen ersten Shim-Schalter (Sw1) aufweist, wobei die Shim-Leiterbahn (C) auf einer um eine Achse (z) gekrümmten Fläche liegt und der erste Shim-Schalter (Sw1) in einem ersten Leiterbahnabschnitt (S1) der Shim-Leiterbahn (C) zur zeitweisen Unterbrechung des supraleitenden Zustandes des ersten Leiterbahnabschnittes (S1) angeordnet ist,
**dadurch gekennzeichnet,**
**dass** die Shim-Leiterbahn (C) um mindestens eine erste Öffnung (O1) und eine zweite Öffnung (O2) verläuft, derart, dass die Shim-Leiterbahn (C) einen ersten umlaufenden Strompfad (L1), einen zweiten umlaufenden Strompfad (L2) und einen dritten umlaufenden Strompfad (L3) umfasst, wobei zwei der drei umlaufenden Strompfade (L1, L2, L3) nur je eine der beiden Öffnungen (O1, O2) umgeben und einer der drei umlaufenden Strompfade (L1, L2, L3) beide Öffnungen (O1, O2) umgibt, und
**dass** der erste Leiterbahnabschnitt (S1), in dem sich der erste Shim-Schalter (Sw1) befindet, Teil von nur dem ersten umlaufenden Strompfad (L1) und dem zweiten umlaufenden Strompfad (L2) ist.

2. Shim-Vorrichtung (D; D'; D") nach Anspruch 1, **dadurch gekennzeichnet, dass** die Shim-Leiterbahn (C) in mindestens einer Lage um die Achse (z) aufgerollt ist und mindestens zwei zur Achse (z) parallel verlaufende Leiterbahnabschnitte aufweist, welche radial übereinanderliegen.

3. Shim-Vorrichtung (D, D'; D") nach einem der vorhergehenden Ansprüche, **dadurch gekennzeichnet, dass** die Shim-Leiterbahn (C) symmetrisch bezüglich einer Spiegelung an einer Normalebene (N) der Achse (z) verläuft.

4. Shim-Vorrichtung (D) nach Anspruch 3, **dadurch gekennzeichnet, dass** der erste umlaufende Strompfad (L1) und der zweite umlaufende Strompfad (L2) bezüglich einer Spiegelung an der Normalebene (N) der Achse (z) jeweils anti-symmetrisch verlaufen.

5. Shim-Vorrichtung (D', D") nach Anspruch 3, **dadurch gekennzeichnet, dass** der erste umlaufende Strompfad (L1) und der zweite umlaufende Strompfad (L2) bezüglich der Spiegelung an der Normalebene (N) der Achse (z) jeweils nicht anti-symmetrisch verlaufen.

6. Shim-Vorrichtung (D, D'; D") nach einem der vorhergehenden Ansprüche, **dadurch gekennzeichnet, dass** der erste umlaufende Strompfad (L1) dieselbe Induktivität wie der zweite umlaufende Strompfad (L2) aufweist.

7. Shim-Vorrichtung (D; D'; D") nach einem der vorhergehenden Ansprüche, **dadurch gekennzeichnet, dass** die Shim-Leiterbahn (C) aus einer HTS-beschichteten Folie gefertigt ist, welche vorzugsweise hochohmig elektrisch überbrückt ist.

8. Shim-Vorrichtung (D") nach einem der vorhergehenden Ansprüche, **dadurch gekennzeichnet, dass** in einem weiteren Leiterbahnabschnitt (S2) ein weiterer Shim-Schalter (Sw2) zur zeitweisen Unterbrechung des supraleitenden Zustandes angeordnet ist, wobei der weitere Leiterbahnabschnitt (S2) Teil des dritten umlaufenden Strompfads (L3) ist.

9. Magnetanordnung für eine Magnetresonanzapparatur, wobei die Magnetanordnung umfasst:
• einen Kryostaten (K) mit einer Raumtemperaturbohrung (B),
• ein im Kryostaten (K) angeordnetes supraleitendes Magnetspulensystem (M) mit
∘ einem Hauptmagneten (MM) zur Erzeugung eines Magnetfeldes in Richtung einer Achse (z) in einem Arbeitsvolumen, durch das die Achse (z) verläuft und
∘ einer Shim-Vorrichtung (D; D'; D") gemäß einem der vorhergehenden Ansprüche zum Einstellen des räumlichen Verlaufs und/oder zur räumlichen Homogenisierung eines vom Hauptmagneten (MM) im Arbeitsvolumen erzeugten Magnetfeldes,
• und eine Ladevorrichtung (E) mit mindestens einer Ladespule (P), welche dazu eingerichtet ist, mit der mindestens einen Shim-Leiterbahn (C) der Shim-Vorrichtung (D; D'; D") induktiv zu koppeln.

10. Magnetanordnung nach Anspruch 9, **dadurch gekennzeichnet, dass** die Ladespule (P) dazu eingerichtet ist, während eines Ladevorgangs der Shim-Vorrichtung unterschiedlich stark mit dem ersten umlaufenden Strompfad (L1) und dem zweiten umlaufenden Strompfad (L2) induktiv zu koppeln.

11. Magnetanordnung nach einem der Ansprüche 9 bis 10 **dadurch gekennzeichnet, dass** verschiedene umlaufende Strompfade (L1, L2, L3) mit derselben Ladespule (P) induktiv koppeln.

12. Verfahren zum Laden einer Shim-Vorrichtung (D, D', D") nach einem der Ansprüche 1 bis 8 in einer Magnetanordnung nach einem der Ansprüche 9 bis 11, wobei eine Änderung des elektrischen Stroms in der Shim-Leiterbahn (C) induktiv mittels einer Änderung eines von der Ladespule (P) erzeugten magnetischen Flusses durch die von der Shim-Leiterbahn (C) eingeschlossene Fläche erfolgt, wobei
I. in einer ersten Phase (I) in beliebiger Reihenfolge der erste Shim-Schalter (Sw1) zur Unterbrechung des supraleitenden Zustandes mindestens zeitweise geöffnet wird, und mittels einer Stromänderung in der Ladespule (P) oder durch Bewegung der Ladespule (P) eine elektrische Stromänderung in mindestens einem der umlaufenden Strompfade (L1, L2, L3) induziert wird,
II. in einer zweiten Phase (II) durch Schließen des ersten Shim-Schalters (Sw1) der erste umlaufende Strompfade (L1) und der zweite umlaufende Strompfad (L2) supraleitend geschlossen werden; und
III. in einer dritten Phase (III) bei geschlossenem ersten Shim-Schalter (Sw1) mittels einer Stromänderung in der Ladespule (P) oder durch Bewegung der Ladespule (P) elektrische Stromänderungen in den umlaufenden Strompfaden (L1, L2, L3) induziert werden.

13. Verfahren nach Anspruch 12, **dadurch gekennzeichnet, dass** der dritte umlaufende Strompfad (L3) während des Ladevorgangs supraleitend geschlossen bleibt.

14. Verfahren nach Anspruch 12, zum Laden einer Shim-Vorrichtung (D") nach Anspruch 8 in einer Magnetanordnung nach einem der Ansprüche 9 bis 11, **dadurch gekennzeichnet,**
**dass** in der ersten Phase (I) vor der Stromänderung in der Ladespule (P) oder Bewegung der Ladespule (P) zusätzlich in dieser Reihenfolge folgende drei Schritte durchgeführt werden:
• Der weitere Shim-Schalter (Sw2) zur Unterbrechung des supraleitenden Zustandes wird mindestens einmal geöffnet.
• Mittels einer Stromänderung in der Ladespule (P) oder durch Bewegung der Ladespule (P) werden weitere elektrische Stromänderungen in den umlaufenden Strompfaden (L1, L2, L3) induziert.
• Der weitere Shim-Schalter (Sw2) wird geschlossen.

## Claims

1. Shim device (D; D'; D") for use in a magnet assembly (M), the shim device (D; D'; D") having at least one HTS (= high-temperature-superconductor-material-comprising) shim conductor track (C) and a first shim switch (Sw1), the shim conductor track (C) lying on a surface that is curved around an axis (z), and the first shim switch (Sw1) being arranged in a first conductor track portion (S1) of the shim conductor track (C) in order to temporarily interrupt the superconducting state of the first conductor track portion (S1),
**characterized in that**
the shim conductor track (C) extends around at least a first opening (O1) and a second opening (O2) such that the shim conductor track (C) has a first circumferential current path (L1), a second circumferential current path (L2) and a third circumferential current path (L3), with two of the three circumferential current paths (L1, L2, L3) each surrounding only one of the two openings (O1, O2) and one of the three circumferential current paths (L1, L2, L3) surrounding the two openings (O1, O2), and **in that**
the first conductor track portion (S1) in which the first shim switch (Sw1) is located is part of only the first circumferential current path (L1) and the second circumferential current path (L2).

2. Shim device (D; D'; D") according to claim 1, **characterized in that** the shim conductor track (C) is coiled in at least one layer around the axis (z) and has at least two conductor track portions that extend in parallel with the axis (z) and lie radially one above the other.

3. Shim device (D, D'; D") according to any of the preceding claims, **characterized in that** the shim conductor track (C) extends symmetrically with respect to a reflection on a normal plane (N) of the axis (z).

4. Shim device (D) according to claim 3, **characterized in that** the first circumferential current path (L1) and the second circumferential current path (L2) each extend antisymmetrically with respect to a reflection on the normal plane (N) of the axis (z).

5. Shim device (D', D") according to claim 3, **characterized in that** the first circumferential current path (L1) and the second circumferential current path (L2) do not each extend antisymmetrically with respect to the reflection on the normal plane (N) of the axis (z).

6. Shim device (D, D'; D") according to any of the preceding claims, **characterized in that** the first circumferential current path (L1) has the same inductance as the second circumferential current path (L2).

7. Shim device (D; D'; D") according to any of the preceding claims, **characterized in that** the shim conductor track (C) is made of an HTS-coated film, which is preferably electrically bridged with high resistance.

8. Shim device (D") according to any of the preceding claims, **characterized in that** a further shim switch (Sw2) is arranged in a further conductor track portion (S2) in order to temporarily interrupt the superconducting state, the further conductor track portion (S2) being part of the third circumferential current path (L3).

9. Magnet assembly for a magnetic resonance apparatus, wherein the magnet assembly comprises:
• a cryostat (K) having a room temperature bore (B),
• a superconducting magnet coil system (M) that is arranged in the cryostat (K) and has
∘ a main magnet (MM) for generating a magnetic field in the direction of an axis (z) in a working volume through which the axis (z) extends and
∘ a shim device (D; D'; D") according to any of the preceding claims for setting the spatial profile and/or for spatially homogenizing a magnetic field generated by the main magnet (MM) in the working volume,
• and a charging device (E) having at least one charging coil (P) which is configured to inductively couple to the at least one shim conductor track (C) of the shim device (D; D'; D").

10. Magnet assembly according to claim 9, **characterized in that**, the charging coil (P) is designed to inductively couple, to varying degrees, to the first circumferential current path (L1) and to the second circumferential current path (L2) during a charging process of the shim device,.

11. Magnet assembly according to either claim 9 or claim 10, **characterized in that** different circumferential current paths (L1, L2, L3) inductively couple to the same charging coil (P).

12. Method for charging a shim device (D, D', D") according to any of claims 1 to 8 in a magnet assembly according to any of claims 9 to 11, wherein a change in the electric current in the shim conductor track (C) takes place inductively by means of a change in a magnetic flux, generated by the charging coil (P), through the surface enclosed by the shim conductor track (C), wherein
I. in a first phase (I), in any sequence, the first shim switch (Sw1) is opened at least temporarily in order to interrupt the superconducting state, and an electric current change is induced in at least one of the circumferential current paths (L1, L2, L3) by means of a current change in the charging coil (P) or by moving the charging coil (P),
II. in a second phase (II), the first circumferential current path (L1) and the second circumferential current path (L2) are superconductingly closed by closing the first shim switch (Sw1); and
III. in a third phase (III), when the first shim switch (Sw1) is closed, electric current changes are induced in the circumferential current paths (L1, L2, L3) by means of a current change in the charging coil (P) or by moving the charging coil (P).

13. Method according to claim 12, **characterized in that** the third circumferential current path (L3) remains superconductingly closed during the charging process.

14. Method according to claim 12, for charging a shim device (D") according to claim 8 in a magnet assembly according to any of claims 9 to 11, **characterized in that**
in the first phase (I), before the current change in the charging coil (P) or the movement of the charging coil (P), the following three steps are additionally carried out, in this order:
• the further shim switch (Sw2) is opened at least once in order to interrupt the superconducting state;
• further electric current changes are induced in the circumferential current paths (L1, L2, L3) by means of a current change in the charging coil (P) or by moving the charging coil (P); and
• the further shim switch (Sw2) is closed.

## Revendications

1. Dispositif de compensation (D ; D' ; D") destiné à être utilisé dans un ensemble d'aimants (M), le dispositif de compensation (D ; D' ; D") comportant au moins une piste conductrice de compensation HTS (C) (= comprenant un matériau supraconducteur à haute température) et un premier commutateur de compensation (Sw1), la piste conductrice de compensation (C) étant située sur une surface incurvée autour d'un axe (z) et le premier commutateur de compensation (Sw1) étant disposé dans une première portion de piste conductrice (S1) de la piste conductrice de compensation (C) pour interrompre temporairement l'état supraconducteur de la première portion de piste conductrice (S1),
**caractérisé en ce que**
la piste conductrice de compensation (C) s'étend autour d'au moins une première ouverture (O1) et d'une deuxième ouverture (O2) de manière que la piste conductrice de compensation (C) comporte un premier chemin de courant tournant (L1), un deuxième chemin de courant tournant (L2) et un troisième chemin de courant tournant (L3), deux des trois chemins de courant tournants (L1, L2, L3) entourant respectivement seulement l'une des deux ouvertures (O1, O2) et l'un des trois chemins de courant tournants (L1, L2, L3) entourant les deux ouvertures (O1, O2), et
la première portion de piste conductrice (S1), dans laquelle se trouve le premier commutateur de compensation (Sw1), fait partie uniquement du premier chemin de courant tournant (L1) et du deuxième chemin de courant tournant (L2).

2. Dispositif de compensation (D ; D' ; D") selon la revendication 1, **caractérisé en ce que** la piste conductrice de compensation (C) est enroulée en au moins une couche autour de l'axe (z) et comporte au moins deux portions de piste conductrice qui s'étendent parallèlement à l'axe (z) et qui sont situées radialement l'une au-dessus de l'autre.

3. Dispositif de compensation (D, D'; D") selon l'une des revendications précédentes, **caractérisé en ce que** la piste conductrice de compensation (C) s'étend symétriquement par rapport à une réflexion sur un plan normal (N) de l'axe (z).

4. Dispositif de compensation (D) selon la revendication 3, **caractérisé en ce que** le premier chemin de courant tournant (L1) et le deuxième chemin de courant tournant (L2) s'étendent de manière antisymétrique par rapport à une réflexion sur le plan normal (N) de l'axe (z) .

5. Dispositif de compensation (D', D") selon la revendication 3, **caractérisé en ce que** le premier chemin de courant tournant (L1) et le deuxième chemin de courant tournant (L2) ne s'étendent pas de manière antisymétrique par rapport à la réflexion sur le plan normal (N) de l'axe (z).

6. Dispositif de compensation (D, D' ; D") selon l'une des revendications précédentes, **caractérisé en ce que** le premier chemin de courant tournant (L1) a la même inductance que le deuxième chemin de courant tournant (L2) .

7. Dispositif de compensation (D ; D' ; D") selon l'une des revendications précédentes, **caractérisé en ce que** la piste conductrice de compensation (C) est réalisée à partir d'un film à revêtement HTS qui est ponté électriquement de préférence à haute résistance.

8. Dispositif de compensation (D") selon l'une des revendications précédentes, **caractérisé en ce qu'**un autre commutateur de compensation (Sw2) est disposé dans une autre portion de piste conductrice (S2) afin d'interrompre temporairement l'état supraconducteur, l'autre portion de piste conductrice (S2) faisant partie du troisième chemin de courant tournant (L3).

9. Ensemble d'aimants destiné à un appareil à résonance magnétique, l'ensemble d'aimants comprenant :
• un cryostat (K) pourvu d'un trou à température ambiante (B),
• un système de bobines magnétiques supraconductrices (M) disposées dans le cryostat (K) et comprenant
∘ un aimant principal (MM) destiné à générer un champ magnétique dans la direction d'un axe (z) dans un volume de travail à travers lequel s'étend l'axe (z) et
∘ un dispositif de compensation (D ; D' ; D") selon l'une des revendications précédentes destiné au réglage de l'allure spatiale et/ou à l'homogénéisation spatiale d'un champ magnétique généré par l'aimant principal (MM) dans le volume de travail,
• et un dispositif de charge (E) comprenant au moins une bobine de charge (P) qui est conçue pour se coupler par induction à l'au moins une piste conductrice de compensation (C) du dispositif de compensation (D ; D' ; D").

10. Ensemble d'aimants selon la revendication 9, **caractérisé en ce que** la bobine de charge (P) est conçue pour se coupler par induction à différents degrés au premier chemin de courant tournant (L1) et au deuxième chemin de courant tournant (L2) pendant un processus de charge du dispositif de compensation.

11. Ensemble d'aimants selon l'une des revendications 9 à 10, **caractérisé en ce que** différents chemins de courant tournants (L1, L2, L3) sont couplés par induction à la même bobine de charge (P).

12. Procédé de charge d'un dispositif de compensation (D, D', D") selon l'une des revendications 1 à 8 dans un ensemble d'aimants selon l'une des revendications 9 à 11, une variation du courant électrique dans la piste conductrice de compensation (C) étant effectuée de manière inductive par variation d'un flux magnétique, généré par la bobine de charge (P), à travers la surface entourée par la piste conductrice de compensation (C),
I. dans une première phase (I), le premier commutateur de compensation (Sw1) étant ouvert au moins temporairement dans un ordre quelconque pour interrompre l'état supraconducteur, et une variation de courant électrique étant induite dans l'un au moins des chemins de courant tournants (L1, L2, L3) par variation du courant dans la bobine de charge (P) ou par déplacement de la bobine de charge (P),
II. dans une deuxième phase (II), le premier chemin de courant tournant (L1) et le deuxième chemin de courant tournant (L2) étant fermés de manière supraconductrice par fermeture du premier commutateur de compensation (Sw1) ; et
III. dans une troisième phase (III), lorsque le premier commutateur de compensation (Sw1) est fermé, des variations de courant électrique étant induites dans les chemins de courant tournants (L1, L2, L3) par variation de courant dans la bobine de charge (P) ou par déplacement de la bobine de charge (P).

13. Procédé selon la revendication 12, **caractérisé en ce que** le troisième chemin de courant tournant (L3) reste fermé de manière supraconductrice pendant le processus de charge.

14. Procédé selon la revendication 12 destiné à charger un dispositif de compensation (D") selon la revendication 8 dans un ensemble d'aimants selon l'une des revendications 9 à 11,
**caractérisé en ce que**
dans la première phase (I), avant la variation de courant dans la bobine de charge (P) ou le déplacement de la bobine de charge (P), les trois étapes supplémentaires suivantes sont réalisées dans cet ordre :
• le commutateur de compensation supplémentaire (Sw2) est ouvert au moins une fois pour interrompre l'état supraconducteur,
• des variations de courant électrique supplémentaires sont induites dans les chemins de courant tournants (L1, L2, L3) par variation du courant dans la bobine de charge (P) ou par déplacement de la bobine de charge (P).
• le commutateur de compensation supplémentaire (Sw2) est fermé.
